Europäisches Patentamt

European Patent Office

Office européen des brevets

(19)

(11) Numéro de publication : **0 306 392 B1**

(12) **FASCICULE DE BREVET EUROPEEN**

(45) Date de publication du fascicule du brevet :
**22.07.92 Bulletin 92/30**

(21) Numéro de dépôt : **88402130.4**

(22) Date de dépôt : **19.08.88**

(51) Int. Cl.⁵ : **G11C 8/00**

(54) **Circuit de détection de transitions d'adresses.**

(30) Priorité : **01.09.87 FR 8712155**

(43) Date de publication de la demande :
**08.03.89 Bulletin 89/10**

(45) Mention de la délivrance du brevet :
**22.07.92 Bulletin 92/30**

(84) Etats contractants désignés :
**DE ES GB IT NL**

(56) Documents cités :
**EP-A- 0 098 164**
**US-A- 4 337 525**
**PATENT ABSTRACTS OF JAPAN, vol. 6, no.**
**175 (P-141)[1053], 9 septembre 1982, page 138**
**P 141; & JP-A-57 92 484 (TOKYOSHIBAURA**
**DENKI K.K.) 09-06-1982**

(73) Titulaire : **SGS-THOMSON**
**MICROELECTRONICS S.A.**
**7, Avenue Galliéni**
**F-94250 Gentilly (FR)**

(72) Inventeur : **Dubujet, Bruno**
**Cabinet Ballot-Schmit 84 avenue Kléber**
**F-75116 Paris (FR)**

(74) Mandataire : **Ballot, Paul Denis Jacques et al**
**Cabinet Ballot-Schmit, 7, rue le Sueur**
**F-75116 Paris (FR)**

## Description

La présente invention concerne un circuit de détection de transitions d'adresses dans un circuit intégré. De plus en plus, pour réduire la consommation des circuits intégrés on ne les active que lorsqu'il y a changement en entrée du niveau de signaux d'adresse ou de signaux de validation du circuit. Lorsque rien ne se passe, la consommation du circuit est faible, mais toutefois non nulle. Des circuits de détection de transitions d'adresses sont déjà connus et permettent de détecter un changement de niveau ou un front en entrée.

Les circuits couramment utilisés sont généralement composés de chaînes d'inverseurs. La méthode de détection consiste à mesurer le niveau des signaux en différents points de cette chaîne et de les combiner dans des portes logiques avec le signal de l'entrée de façon à obtenir une impulsion en sortie quand il y a un changement de niveau en entrée. Le brevet US-A-4 337 525 en donne un exemple.

Malheureusement, l'impulsion générée en sortie dès qu'il y a eu un changement de niveau en entrée est nécessairement retardée par le temps de propagation dans les inverseurs car le circuit est en série. De plus, la durée de l'impulsion et son retard par rapport à la transition sont liés et sont fonction du temps de transfert dans les inverseurs. Si on veut une impulsion large pour pouvoir bien l'utiliser elle aura d'autant plus de retard.

L'invention propose pour remédier à ces inconvénients un circuit de détection de transitions d'adresses qui minimise le retard de l'impulsion générée en sortie dès qu'il y a un changement de niveau en entrée.

L'invention concerne donc un circuit de détection de transitions d'adresses dans un circuit intégré consistant à générer une impulsion en sortie dès qu'il y a eu un changement d'adresse en entrée, tel que défini dans la revendication 1.

D'autres caractéristiques et avantages de l'invention apparaîtront à la lecture de la description qui va suivre avec références aux dessins annexés dans lesquels :

– la figure 1 représente un circuit de détection de transit ions d'adresses en technologie CMOS selon l'art antérieur ;

– la figure 2 représente un disgramme des temps des signaux en différents points du circuit selon l'art antérieur ;

– la figure 3 représente une constitution possible du bloc logique de comparaison mentionné en 6 sur la figure 1 ;

– la figure 4 représente un circuit de détection de transitions d'adresses en technologie CMOS selon l'invention ;

– la figure 5 représente un diagramme des temps des signaux en différents points du circuit selon l'invention.

– la figure 6 représente une réalisation particulière d'un circuit selon l'invention.

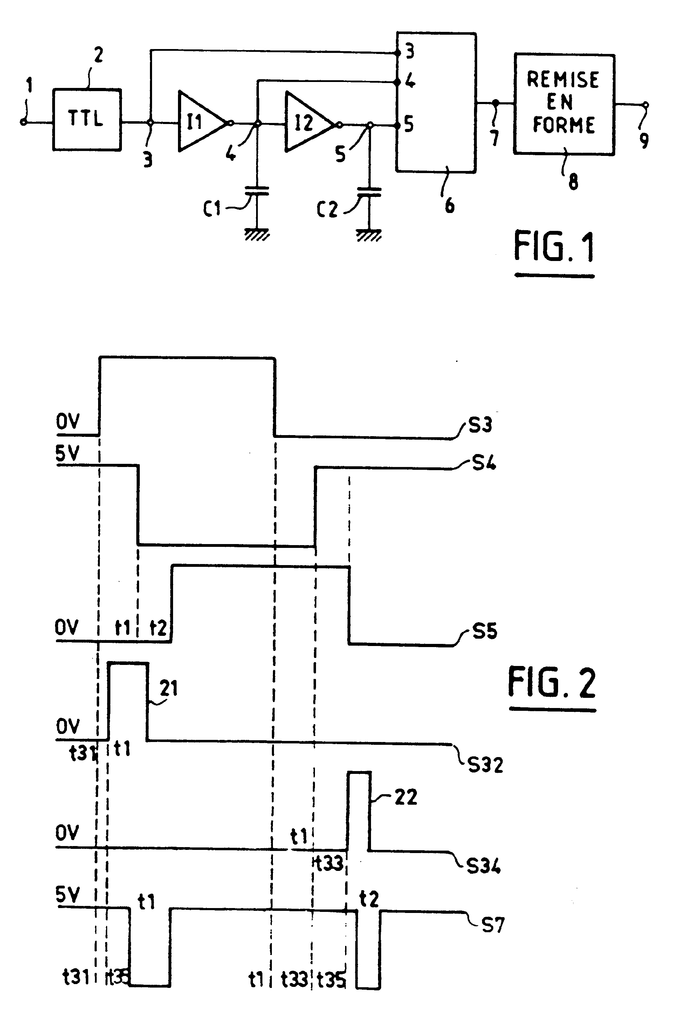

La figure 1 représente un circuit de détection de transitions d'adresses selon l'art antérieur en technologie CMOS.

La borne d'entrée 1 de ce circuit est reliée à un bloc adaptateur 2 de technologie TTL (pour transistor transistor logic en langue anglaise) en technologie CMOS de type connu. En effet. les signaux traités dans un circuit intégré en technologie CMOS peuvent provenir de circuits extérieurs réalisés en technologie différente, par exemple en technologie bipolaire TTL. Cet adaptateur 2 permet de travailler sur des tensions de niveau 0 Volt ou 5 Volts.

La sortie 3 du bloc adaptateur 2 arrive sur l'entrée d'un inverseur $I_1$, suivi d'une capacité $C_1$ en parallèle. La sortie 4 de l'inverseur $I_1$ arrive sur l'entrée d'un inverseur $I_2$, suivi d'une capacité $C_2$ en parallèle. La sortie 5 de l'inverseur $I_2$, la sortie 4 de l'inverseur $I_1$ et la sortie 3 du bloc adaptateur 2 arrivent sur l'entrée d'un bloc logique de comparaison 6. Les capacités $C_1$ et $C_2$ ajoutées en parallèle derrière chaque inverseur $I_1$ et $I_2$ permettent d'augmenter le temps de transfert dans chaque inverseur.

Le temps de transfert dans un inverseur est de l'ordre d'une nanoseconde. Le fait d'ajouter une capacité permet d'augmenter ce temps d'environ 2 à 3 ns par inverseur. C'est volontairement que l'on recherche un temps de transfert plus long. Car au moment où l'on compare les signaux en 3, en 4 ou en 5 dans le bloc logique de comparaison 6 en l'absence de capacité, il peut être difficile de voir que les signaux en 4 et en 5, par exemple, ont la même valeur pendant seulement 1 ns.

C'est en sortie 7 du bloc logique de comparaison 6 que l'on obtient l'impulsion.

Il faut noter que l'impulsion générée en 7 n'est généralement pas de bonne qualité et n'est pas réellement utilisable de manière fiable telle quelle. Ceci est dû au fait que le bloc logique de comparaison 6 et les inverseurs $I_1$, $I_2$ contiennent un grand nombre de transistors. Il faudra remettre en forme l'impulsion générée en 7 dans un circuit de type connu 8, mis en série dans le montage. Ce circuit retarde de façon non négligeable l'impulsion générée. La sortie 9 de ce circuit 8 activera le circuit qui suit, non représenté ici, dès qu'on aura généré une impulsion.

Le bloc logique de comparaison 6 est constitué de portes logiques. Il reçoit en entrée les signaux $S_3$, sur la borne 3, $S_4$ sur la borne 4, $S_5$ sur la borne 5 et doit générer une impulsion en sortie 7 dès qu'il y a eu un changement de niveau en entrée 1.

Pour simplifier la description qui va suivre, nous considérerons l'entrée du circuit en 3, en sortie du bloc adaptateur TTL 2 et la sortie en 7 avant la remise en forme 8.

La figure 2 représente entre autre les diagrammes des temps des signaux $S_3$, $S_4$, $S_5$.

Le temps de transfert dans l'inverseur $I_1$ suivi de la capacité $C_1$ est $t_1$.

Le temps de transfert dans l'inverseur $I_2$ suivi de la capacité $C_2$ est $t_2$.

Le signal noté $S_3$ représente une transition d'adresse de 0V vers 5V puis de 5V vers 0V.

Le signal $S_4$ est inversé et les transitions d'adresses arrivent avec le retard $t_1$.

Le signal $S_5$ est inversé par rapport au signal $S_4$. La transition arrive avec le retard $t_2$. Elle arrive aussi avec le retard $t_1 + t_2$ par rapport à la transition du signal $S_3$.

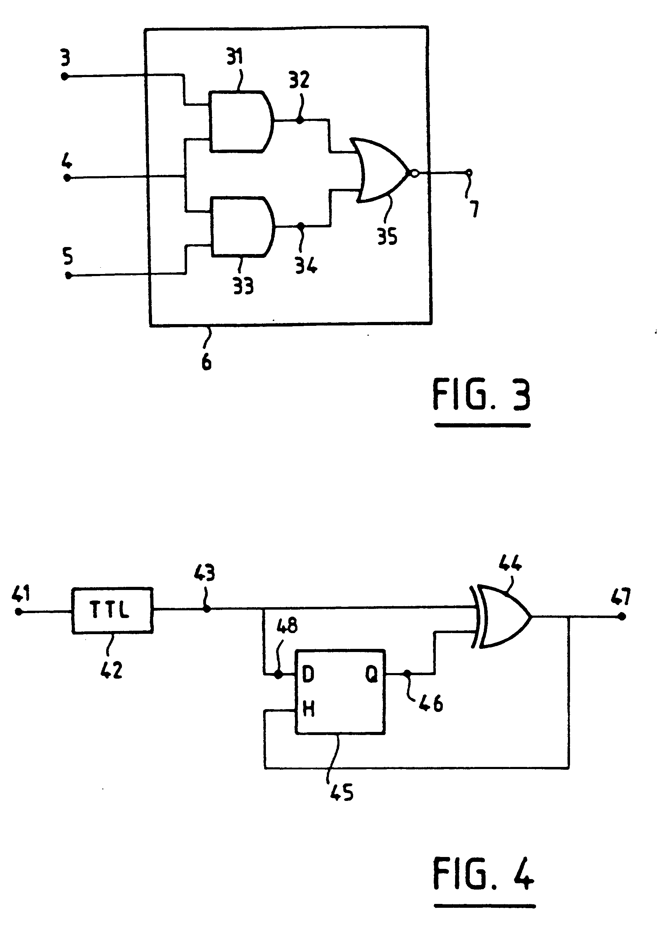

Pour obtenir l'impulsion sur la borne 7 dès qu'il y a eu la transition d'adresse, le bloc de portes logiques 6 peut être constitué de la combinaison des portes logiques représentées sur la figure 3. Cet exemple n'est pas le seul, il existe d'autres combinaisons possibles.

Sur la figure 3, la sortie 3 du bloc adaptateur et la sortie 4 de l'inverseur $I_1$ constituent les entrées d'une porte logique ET 31 internationalement connue sous la dénomination AND.

La sortie 4 et l'inverseur $I_1$ et la sortie 5 de l'inverseur $I_2$ constituent les entrées d'une autre porte ET 33. La sortie 32 de la porte ET 31 et la sortie 34 de la porte ET 33 constituent les entrées d'une porte logique NI 35 internationalement connue sous la dénomination NOR. La sortie de cette porte NI 35 arrive sur la borne 7.

La figure 2 représente aussi le diagramme des temps des signaux $S_{32}$ sur la borne 32, $S_{34}$ sur la borne 34 et $S_7$ sur la borne 7.

Le retard lié à la porte ET 31 est $t_{31}$. Le retard lié à la porte ET 33 est $t_{33}$. Le retard lié à la porte NI 35 est $t_{35}$.

On obtient en 32 une impulsion 21 de durée $t_1$ ayant comme retard $t_{31}$ par rapport au front montant de la transition du signal $S_3$.

On obtient en 34 une impulsion 22 de durée $t_2$ ayant comme retard $t_1 + t_{33}$ par rapport au front descendant de la transition du signal $S_3$.

On obtient en 7 les deux impulsions 21 et 22 décrites plus haut : la première 21 correspond au front montant de la transition du signal $S_3$ son retard est $t_{31} + t_{35}$ et sa durée est $t_1$, la seconde 22 correspond au front descendant de la transition du signal $S_3$ son retard est $t_1 + t_{33} + t_{35}$ et sa durée est $t_2$.

Au moins l'une de ces impulsions aura un retard lié au temps de transfert de l'un des inverseurs. Dans l'exemple décrit précédemment, il s'agit de la deuxième impulsion 22 et ce retard est $t_1$. Un agencement différent des portes logiques du bloc 6 pourra donner un retard sur la première impulsion.

En sortie 9, on s'aperçoit que les impulsions ont dans le pire cas un retard : lié au temps de transfert dans les inverseurs, dans les portes logiques et dans le circuit de remise en forme.

La durée de ces impulsions est fonction du temps de transfert dans les inverseurs.

On recherche donc en sortie 9 que l'impulsion qui servira à activer le circuit soit suffisamment large pour être détectée mais qu'elle ne prenne pas trop de retard par rapport à la transition d'adresse à l'entrée.

Le circuit selon l'invention minimise ce retard car les éléments de ce circuit ne sont plus en série mais en parallèle.

La figure 4 représente un circuit de détection de transitions d'adresses selon l'invention.

La borne d'entrée 41 est reliée comme précédemment à un bloc adaptateur 42 de technologie TTL en technologie CMOS.

La sortie 43 du bloc adaptateur 42 est reliée d'une part, à l'une des entrées d'un comparateur 44 et d'autre part, à l'entrée 48 d'une mémoire commandée 45. L'exemple représente une porte OU exclusif comme comparateur et une bascule D comme mémoire commandée.

La sortie 46 de la bascule D arrive sur l'autre entrée de la porte OU exclusif. La sortie de la porte OU exclusif se fait sur la borne 47. Le signal $S_{47}$ sur la borne 47 sert aussi de signal d'horloge sur la borne H de la bascule D.

Le circuit que l'on veut activer dès que l'on a détecté une transition d'adresse sera branché en série avec le comparateur sur la borne 47. Il n'est pas représenté sur cette figure. Il est possible d'employer d'autres comparateurs ou d'autres types de mémoire.

En particulier, pour les besoins du circuit que l'on veut activer, on peut être amené à utiliser comme comparateur une porte NI exclusif internationalement connue sous la dénomination NOR exclusif. Le NI exclusif présente une table de vérité inverse de celle du OU exclusif.

Nous considérerons aussi que l'entrée du circuit se fait sur la borne 43 à la sortie du bloc adaptateur TTL pour simplifier la description.

Le principe de fonctionnement de ce circuit est le suivant :

On compare en permanence dans la porte OU exclusif 44 le signal $S_{43}$ sur la borne 43 et le signal $S_{46}$ sur la borne 46. Le signal $S_{46}$ est le signal mémorisé. Il a l'état du signal $S_{43}$ avant la transition.

En sortie, le signal $S_{47}$ est d'un premier niveau logique tant que les signaux $S_{43}$ et $S_{46}$ ont le même niveau logique. Dès que les signaux $S_{43}$ et $S_{46}$ prennent des niveaux logiques différents le signal $S_{47}$ passe à un deuxième niveau logique. Dans l'exemple que nous décrivons, le premier niveau est le niveau bas quand les signaux $S_{43}$ et $S_{46}$ ont la même valeur. Le deuxième niveau est le niveau haut quand les signaux $S_{43}$ et $S_{46}$ ont des valeurs différentes. La mémorisation du signal $S_{46}$ se fait sur le front montant du signal d'horloge $S_{47}$. En technologie CMOS le niveau haut est à 5 Volts et le niveau bas à 0 Volt.

Les diagrammes des temps des signaux $S_{43}$, $S_{46}$

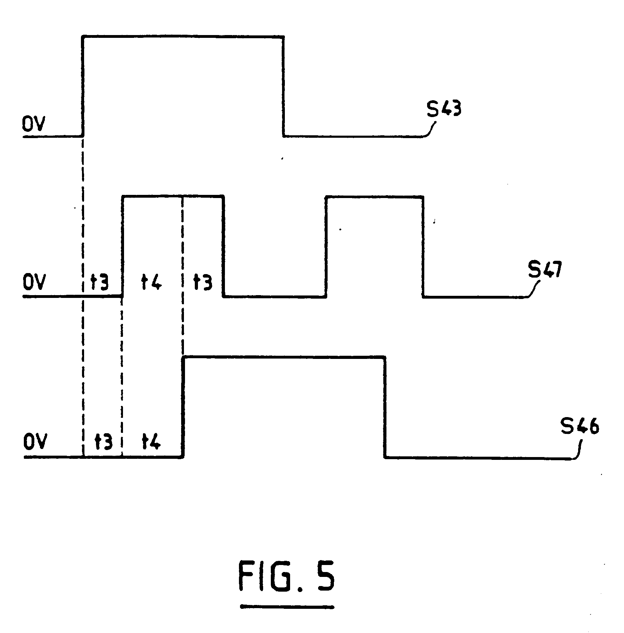

et $S_{47}$ sont représentés à la figure 5.

Dès que les signaux $S_{43}$ et $S_{46}$ ont des valeurs différentes, le signal $S_{47}$ passe au niveau haut. On génère en 47 le front montant d'une impulsion qui correspond à la détection d'un changement de niveau du signal $S_{43}$.

A ce moment, le signal d'horloge $S_{47}$ sur la borne H de la bascule D active la commande de mémorisation. Le signal $S_{46}$ prend la nouvelle valeur du signal $S_{43}$ après la transition. Les signaux $S_{43}$ et $S_{46}$ ayant de nouveau la même valeur, le signal $S_{47}$ passe au niveau bas. On a généré le front descendant de l'impulsion. Le retard de l'impulsion en sortie 47 par rapport à la transition en 43 correspond au temps de transfert $t_3$ dans la porte OU exclusif 44. La durée de l'impulsion générée est égale à la somme du temps de transfert $t_4$ dans la bascule D 45 et du temps de transfert $t_3$ dans la porte OU exclusif 44.

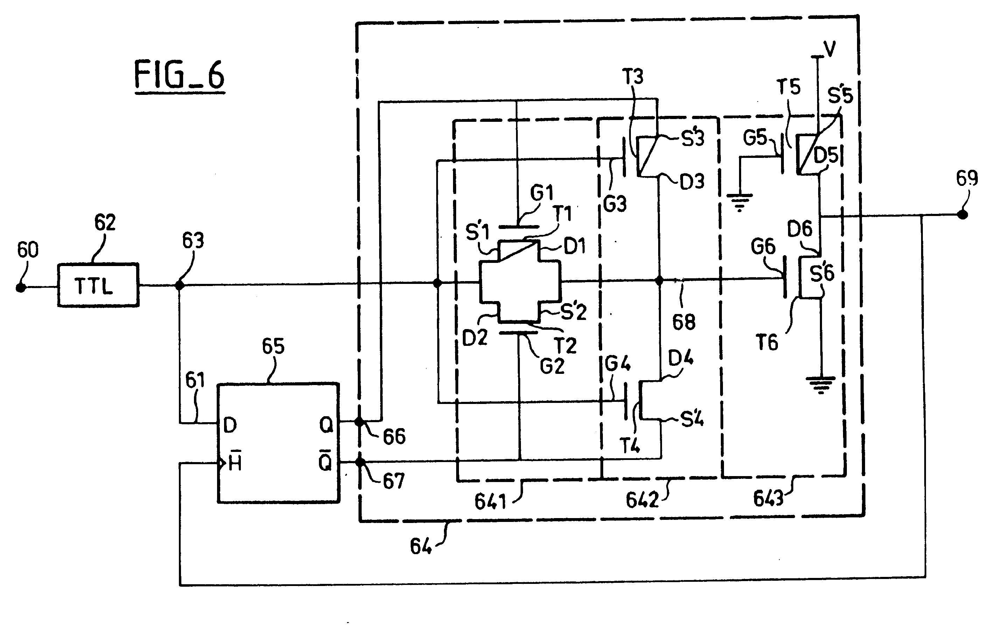

La figure 6 représente une réalisation particulière d'un circuit de transitions d'adresses en technologie CMOS conforme à l'invention. L'entrée du circuit se fait sur la borne 60. Elle est suivie d'un bloc adaptateur 62 de technologie TTL en technologie CMOS. La sortie 63 de ce bloc 62 est reliée d'une part à l'une des entrées du comparateur 64 et d'autre part à l'entrée 61 d'une mémoire commandée 65.

Le comparateur 64 est constituée d'une porte NI exclusif. La mémoire commandée 65 est une bascule D. Une porte NI exclusif ne peut être réalisée de manière simple en technologie CMOS.

Dans notre exemple elle est constituée d'une porte OU exclusif comprenant un ensemble porte de transfert 641 et pseudo-inverseur 642, suivie d'un inverseur 643 en série.

La circuiterie 642 est appelée "pseudo-inverseur" car elle est soit un inverseur soit un amplificateur non-inverseur suivant la valeur des signaux présents sur les sorties Q 66 et $\overline{Q}$ 67 de la bascule D 65.

Les transistors $T_1$ de type PMOS et $T_2$ de type NMOS forment la porte de transfert 641. La source $S'_1$ du transistor $T_1$ est reliée au drain $D_2$ du transistor $T_2$. Ils sont alimentés par le signal $S_{63}$ sur la borne 63.

Le drain $D_1$ du transistor $T_1$ est relié à la source $S'_2$ du transistor $T_2$ sur la borne 68 de sortie de la porte OU exclusif (641, 642).

La grille $G_1$ du transistor $T_1$ reçoit le signal $S_{66}$ qui correspond à la sortie Q 66 de la bascule D 65.

La grille $G_2$ du transistor $T_2$ reçoit le signal $S_{67}$ qui correspond à la sortie $\overline{Q}$ 67 de la bascule D 65.

Les transistors $T_3$ de type PMOS et $T_4$ de type NMOS forment le "pseudo-inverseur" 642.

Le drain $D_3$ du transistor $T_3$ est relié au drain $D_4$ du transistor $T_4$ sur la borne 68 de sortie de la porte OU exclusif (641, 642).

La source $S'_3$ du transistor $T_3$ reçoit le signal $S_{66}$ qui correspond à la sortie 66 de la bascule D 65.

La source $S'_4$ du transistor $T_4$ reçoit le signal $S_{67}$ qui correspond à la sortie 67 de la bascule D 65.

La grille $G_3$ du transistor $T_3$ et la grille $G_4$ du transistor $T_4$ sont communes et sont alimentées par le signal $S_{63}$.

Le fonctionnement de la porte OU exclusif (641, 642) est le suivant :

Lorsque le signal $S_{66}$ sur la borne 66 est au niveau haut, la porte de transfert 641 est fermée et le pseudo-inverseur 642 conduit.

Le signal $S_{68}$ sur la borne 68 en sortie de la porte OU exclusif (641, 642) est inversé par rapport au signal d'entrée $S_{63}$ sur la borne 63.

Lorsque le signal $S_{66}$ sur la borne 66 est au niveau bas, la porte de transfert 641 est passante et le pseudo-inverseur 642 est bloqué.

Le signal $S_{68}$ sur la borne 68 en sortie de la porte OU exclusif (641, 642) est de même niveau que le signal d'entrée $S_{63}$ sur la borne 63.

Le signal $S_{68}$ est ensuite inversé dans un inverseur 643 formé des transistors $T_5$ de type PMOS et $T_6$ de type NMOS.

Le signal $S_{68}$ arrive sur la grille $G_6$ du transistor $T_6$, la grille $G_5$ du transistor $T_5$ est à la masse. La source $S'_5$ du transistor $T_5$ est porté au potentiel +V tension d'alimentation du circuit. La source $S'_6$ du transistor $T_6$ est à la masse.

Les drains $D_5$ du transistor $T_5$ et $D_6$ du transistor $T_6$ sont communs sur la borne 69. Le signal $S_{69}$ sur la borne 69 alimente le circuit que l'on veut activer mais il n'est pas représenté ici.

Ce signal $S_{69}$ sert aussi de signal d'horloge sur la borne $\overline{H}$ de la bascule D 65. La bascule D 65 réagit alors au front descendant du signal $S_{69}$.

Le retard et la durée de l'impulsion que l'on génère dans un circuit conforme à l'invention représenté sur la figure 4 peuvent être calculés de la manière suivante:

Le temps de transfert $t_3$ dans une porte OU exclusif est faible de l'ordre de 1ns.

Le temps de transfert $t_4$ dans une bascule D est de l'ordre de 2 à 3 ns.

En se référant à la figure 4, on s'aperçoit que le retard de l'impulsion générée en 47 par rapport à la transition en 43 sera de :

$$t = t_3$$
$$t = 1ns.$$

La durée de l'impulsion générée en 47 sera :

$$T = t_3 + t_4.$$

Dans le pire des cas, la valeur T sera de l'ordre de 4ns.

Dans l'exemple décrit comme art antérieur et représenté à la figure 1, il ne faut pas négliger le temps de transfert $t_8$ dans le circuit de remise en forme 8 qui est de l'ordre de 2ns. Le temps de transfert dans un inverseur suivi d'une capacité est de l'ordre de 3 à 4ns.

Le retard de l'impulsion générée en 9 par rapport à la transition en 3 sera dans le pire cas (impulsion 22) :

$t' = t_1 + t_{33} + t_{35} + t_8$

$t'$ sera de l'ordre de 15ns.

La durée de l'impulsion générée en 9 sera :

$T' = t_2$

$T'$ sera de l'ordre de 4ns.

Le gain global avec un circuit selon l'invention au niveau du retard de l'impulsion est de l'ordre de 10ns par rapport à l'art antérieur.

D'autres avantages apparaissent également :

Dans le circuit selon l'invention, on est sûr d'avoir enregistré la transition, car le système est bouclé. On est bien sûr qu'au moment où l'on génère le front montant de l'impulsion c'est que les valeurs des signaux $S_{43}$ et $S_{46}$ sont différentes et qu'il y a eu transition d'adresse. De plus, le front descendant de l'impulsion ne sera généré que lorsque la nouvelle valeur du signal $S_{43}$ aura été mémorisée en 46.

Ce circuit n'a qu'un seul état stable lorsque la valeur du signal d'entrée $S_{43}$ est égale à la valeur du signal mémorisé $S_{46}$. La sécurité de ce circuit est beaucoup plus grande que celle des circuits utilisés jusqu'à présent.

Dans le circuit utilisé précédemment, on n'était pas vraiment sûr de détecter la transition si le temps de transfert des inverseurs était mal calculé. la comparaison des signaux $S_3$, $S_4$, $S_5$ pouvait donner une impulsion en 7 si faible qu'elle pouvait être difficilement décelable.

C'est pourquoi en recherchant une impulsion ayant une durée satisfaisante, on augmentait son retard.

A la mise sous tension, il n'y a pas de problème si la valeur du signal mémorisé $S_{46}$ est différente de celle du signal d'entrée $S_{43}$ ou génère une impulsion et le signal mémorisé $S_{46}$ change de niveau. On retombe dans le cas où les deux signaux $S_{43}$ et $S_{46}$ ont la même valeur et où le circuit est stable.

La bascule 45 peut également être utilisée pour autre chose et l'on se servira de la valeur du signal mémorisé $S_{46}$ ou de son inverse. Cela entraînera un gain de place dans le circuit intégré, ce qui est toujours recherché.

## Revendications

1. Circuit de détection de transitions d'adresses dans un circuit intégré consistant à générer une impulsion en sortie (47) dès qu'il y a un changement d'adresse en entrée (41), comportant une entrée de signal logique (43) recevant un signal d'adresse et un moyen de comparaison (44) ayant une entrée reliée à l'entrée de signal logique (43) et fournissant un premier niveau logique a ladite sortie (47) lorsque ses entrées reçoivent un même niveau logique et un deuxième niveau logique lorsque ses entrées reçoivent des niveaux logiques différents, caractérisé en ce que :

– il comporte en outre un moyen de mémorisation (45) du type bascule D ayant une entrée (48) reliée à l'entrée de signal logique (43), pour mémoriser l'état de celle-ci,

– le moyen de comparaison (44) a une entrée reliée à la sortie du moyen de mémorisation (46), la sortie (47) du moyen de comparaison étant connectée à une entrée d'horloge (4) du moyen de mémorisation.

2. Circuit de détection de transitions d'adresses selon la revendication 1, caractérisé en ce que le moyen de comparaison est une porte OU-Exclusif dont l'une des entrées est le signal d'entrée et dont l'autre entrée est le signal de sortie du moyen de mémorisation.

3. Circuit de détection de transitions d'adresses selon la revendication 1, caractérisé en ce que le moyen de comparaison est une porte NI exclusif dont l'une des entrées est le signal d'entrée et dont l'autre entrée est le signal de sortie du moyen de mémorisation.

## Patentansprüche

1. Schaltung zur Erfassung von Adressenumschaltungen in einem integrierten Schaltkreis, bestehend darin, daß ein Ausgangsimpuls (47) erzeugt wird, sobald eine Eingangsadressen(41)-Änderung aufgetreten ist, umfassend einen logischen Signaleingang (43), der ein Adressignal aufnimmt, und ein Vergleichsmittel (44), das einen mit dem logischen Signaleingang (43) verbundenen Eingang aufweist, wobei es dem Ausgang (47) einen ersten logischen Pegel, wenn seine Eingänge einen gleichen logischen Pegel aufnehmen, und einen zweiten logischen Pegel liefert, wenn seine Eingänge verschiedene logische Pegel aufnehmen, dadurch gekennzeichnet, daß

– er außerdem ein Speichermittel (45) vom Kipp-Typ D umfaßt, das einen mit dem logischen Signaleingang (43) verbundenen Eingang (48) aufweist, um dessen Zustand zu speichern,

– das Vergleichsmittel (44) einen mit dem Ausgang des Speichermittels (46) verbundenen Eingang aufweist, wobei der Ausgang (47) das Vergleichsmittel mit einem Takteingang (H) des Speichermittels verbunden ist.

2. Schaltung zur Erfassung von Adressumschaltungen nach Anspruch 1, dadurch gekennzeichnet, daß das Vergleichsmittel ein exklusives ODER-Glied ist, dessen eine Eingabe das Eingangssignal und dessen andere Eingabe das Ausgangssignal des Speichermittels ist.

3. Schaltung zur Erfassung von Adressenumschaltungen nach Anspruch 1, dadurch gekennzeichnet, daß das Vergleichsmittel ein exklusives NOR-Glied ist, dessen eine Eingabe das Eingangssignal ist und dessen andere Eingabe das Ausgangssignal des Speichermittels ist.

**Claims**

1. A circuit for detecting address transitions in an integrated circuit which generates an output pulse (47) when there is a change in address at the input (41), comprising a logic signal input (43), which receives an address signal, and comparison means (44) having one input connected to the logic signal input (43) and supplying a first logic level at said output (47) when its inputs receive the same logic level and a second logic level when its inputs receive different logic levels, characterized in that:
   – it also comprises storage means (45) of the D-type flip-flop kind having one input (48) connected to the the logic signal input (43) in order to store the state of the latter,
   – the comparison means (44) has one input connected to the output (46) of the storage means, the output (47) of the comparison means being connected to a clock input (H) of the storage means.

2. An address transition detection circuit as claimed in claim 1, characterized in that the comparison means is an exclusive-OR gate one input of which is the input signal and the other input of which is the output signal of the storage means.

3. An address transition detection circuit as claimed in claim 1, characterized in that the comparison means is an exclusive-NOR gate one input of which is the input signal and the other input of which is the output signal of the storage means.

FIG.1

FIG.2

FIG. 3

FIG. 4

FIG. 5

FIG_6